# EUROPEAN PATENT APPLICATION

(11) **EP 4 622 231 A1**
(43) Date of publication of application: **24.09.2025**
(21) Application number: 23901123.2
(22) Date of filing: 07.12.2023
(51) Int. Cl.: H04M 1/72454, H04M 1/02, G06F 3/041

(54) **ROLLABLE ELECTRONIC DEVICE COMPRISING SENSING CIRCUIT**

(30) Priority: 08.12.2022 KR 20220170617; 26.12.2022 KR 20220184744
(71) Applicant: Samsung Electronics Co., Ltd., Suwon-si, Gyeonggi-do 16677 (KR)
(72) Inventor: AHN, Jaeuk, Suwon-si Gyeonggi-do 16677 (KR); KANG, Hyunggwang, Suwon-si Gyeonggi-do 16677 (KR); KIM, Junhyuk, Suwon-si Gyeonggi-do 16677 (KR); JEONG, Hoyoung, Suwon-si Gyeonggi-do 16677 (KR); CHO, Hyoungtak, Suwon-si Gyeonggi-do 16677 (KR); CHOI, Junwoo, Suwon-si Gyeonggi-do 16677 (KR); KIM, Sukdong, Suwon-si Gyeonggi-do 16677 (KR); SEO, Soohyun, Suwon-si Gyeonggi-do 16677 (KR); HONG, Hyunju, Suwon-si Gyeonggi-do 16677 (KR)
(74) Representative: Gulde & Partner
(86) International application number: PCT/KR2023/020100
(87) International publication number: WO 2024/123106

(57) **Abstract**

An electronic device can be provided. The electronic device may comprise: a first housing including a first cover member and a frame positioned inside the first cover member; a second housing of which at least a portion is housed in the first cover member, and which includes a second cover member including a metal area and a non-metal area surrounding the metal area and slides with respect to the first housing; a display configured to unroll on the basis of the sliding of the second housing; a circuit board disposed within the second housing; a connection member contacting the metal area of the second cover member and electrically connecting the metal area to the circuit board; a sensing circuit disposed on the circuit board and including a grip sensor configured to sense contact of a user with the metal area; an application processor disposed on the circuit board; and a memory storing instructions. When executed by the application processor, the instructions may cause the electronic device to perform at least one operation. The at least one operation may include an operation for generating a signal for controlling the movement of the second housing on the basis of an electrical signal sensed by the sensing circuit.

## Description

### [Technical Field]

Various embodiments of the disclosure relate to a rollable electronic device including a sensing circuit.

### [Background Art]

Due to advancement in information and communication technology and semiconductor technology, various functions are being integrated into a single portable electronic device. For example, an electronic device may implement not only communication functions, but also entertainment functions such as gaming, multimedia functions such as music/video playback, communication and security functions for mobile banking or the like, and functions for schedule management and an electronic wallet function. These electronic devices are being miniaturized to be conveniently carried by users.

As mobile communication service extends into the multimedia service domain, it is necessary to increase the display sizes of electronic devices in order to allow users to fully utilize multimedia services, as well as voice calls and short message services. However, the display sizes of electronic devices may be in a trade-off relationship with the miniaturization of electronic devices.

The above-described information may be provided as related art for the purpose of helping to understand the disclosure. No claim or determination is made as to whether any of the foregoing may be applied as prior art with respect to the disclosure.

### [Detailed Description of the Invention]

### [Technical Solution]

According to an embodiment of the disclosure, an electronic device may include a first housing including a first cover member and a frame positioned within the first cover member, a second housing comprising a second cover member at least partially accommodated within the first cover member and including a metal area and a non-metal area surrounding the metal area, and configured to slide relative to the first housing, a display configured to be unfolded based on the sliding of the second housing, a circuit board disposed within the second housing, a connection member contacting the metal area of the second cover member and electrically connecting the metal area to the circuit board, a sensing circuit disposed on the circuit board and including a grip sensor configured to detect user contact with the metal area, and at least one application processor disposed on the circuit board and configured to generate a signal for controlling the movement of the second housing based on an electrical signal detected by the sensing circuit.

According to an embodiment, the electronic device may include memory configured to store instructions. The instructions, when executed by the at least one application processor, may cause the electronic device to perform at least one operation. The at least one operation may include generating a signal to control movement of the second housing based on an electrical signal detected by the sensing circuit.

According to an embodiment of the disclosure, an electronic device may include a first housing including a first cover member and a frame positioned within the first cover member, a second housing configured to slide relative to the first housing, and including a second cover member at least partially accommodated within the first cover member, a rear cover covering at least a portion of the second cover member, and a rear surface plate covering at least a portion of the rear cover, a display configured to be unfolded based on the sliding of the second housing, a circuit board disposed within the second housing, a touch sensor disposed on the second cover member and configured to detect user input, a sensing circuit disposed on the circuit board and configured to detect the user contact with the touch sensor, and an application processor disposed on the circuit board and configured to generate a signal for controlling the movement of the second housing based on an electrical signal determined in the sensing circuit.

According to an embodiment, the electronic device may include memory configured to store instructions. The instructions, when executed by the at least one application processor, may cause the electronic device to perform at least one operation. The at least one operation may include generating a signal to control movement of the second housing based on an electrical signal determined by the sensing circuit.

According to an embodiment of the disclosure, an electronic device may include a first housing including a first cover member, and a frame positioned within the first cover member, a second housing configured to slide relative to the first housing and including a second cover member at least partially accommodated within the first cover member, the second cover member including a metal area and a non-metal area surrounding the metal area, a display configured to be unfolded based on the sliding of the second housing, a circuit board disposed within the second housing, a connection member that is in contact with the metal area of the second cover member and electrically connects the metal area to the circuit board, a touch sensor disposed on the second cover member and configured to detect user input, a sensing circuit disposed on the circuit board and configured to determine user contact relative to at least one of the connection member or the touch sensor, and at least one application processor disposed on the circuit board and configured to generate a signal for controlling the movement of the second housing based on an electrical signal detected by the sensing circuit.

According to an embodiment, the electronic device may include memory configured to store instructions. The instructions, when executed by the at least one application processor, may cause the electronic device to perform at least one operation. The at least one operation may include generating a signal to control movement of the second housing based on an electrical signal detected by the sensing circuit.

According to an embodiment of the disclosure, a method of operating an electronic device may include an operation in which a processor of the electronic device commands the slide-in operation of the electronic device, an operation in which a motor of the electronic device is driven, an operation in which a sensing circuit is driven by the processor, an operation in which the sensing circuit detects whether a user is in contact using a grip sensor connected to the sensing circuit, an operation in which the processor identifies the sliding distance in the electronic device when the sensing circuit detects the user contact via the grip sensor, and an operation in which the processor transmits a signal for stopping the sliding or for slide-out when the sliding distance is determined to be less than a predetermined distance.

According to an embodiment of the disclosure, a method of operating an electronic device may include an operation in which a processor of the electronic device commands the slide-in operation of the electronic device, an operation in which a motor of the electronic device is driven, an operation in which a sensing circuit is driven by the processor, an operation in which the sensing circuit detects whether a user is in contact using a touch sensor connected to the sensing circuit, an operation in which the processor identifies the sliding distance in the electronic device when the sensing circuit detects the user contact via the touch sensor, and an operation in which the processor transmits a signal for stopping the sliding or for slide-out when the sliding distance is determined to be less than a predetermined distance.

### [Brief Description of Drawings]

FIG. 1 is a block diagram of an electronic device according to an embodiment of the disclosure in a network environment.
FIG. 2 is a view illustrating the state in which a second display area of a display according to an embodiment of the disclosure is accommodated in a housing.
FIG. 3 is a view illustrating the state in which the second display area of the display according to an embodiment of the disclosure is exposed to the exterior the housing.
FIG. 4 is an exploded perspective view of an electronic device according to an embodiment of the disclosure.
FIG. 5A is a cross-sectional view of an embodiment of the disclosure, taken along line A-A' in FIG. 2. FIG. 5B is a cross-sectional view of an embodiment of the disclosure, taken along line B-B' in FIG. 3.
FIG. 6 is a perspective view of a driving structure according to an embodiment of the disclosure.
FIG. 7 is an exploded perspective view of an electronic device according to an embodiment of the disclosure.
FIG. 8 is a front view illustrating a second cover member according to an embodiment of the disclosure.
FIG. 9 is a view illustrating a structure for detecting user contact on the left side of an electronic device according to an embodiment of the disclosure.
FIGS. 10A and 10B are views illustrating an operation for detecting user contact on the left side of an electronic device according to an embodiment of the disclosure.
FIG. 11 is a view illustrating a structure for detecting user contact on the right side of an electronic device according to an embodiment of the disclosure.
FIG. 12 is a view illustrating an operation for detecting user contact on the right side of an electronic device according to an embodiment of the disclosure.
FIG. 13 is a perspective view of an electronic device including a touch sensor according to an embodiment of the disclosure.
FIG. 14 is a view illustrating an operation for detecting user contact on the rear side of the electronic device according to an embodiment of the disclosure.
FIG. 15 is a flowchart illustrating the operation of an electronic device according to an embodiment of the disclosure.
FIG. 16 is a perspective view illustrating an auxiliary touch sensor and a first cover member according to an embodiment of the disclosure.
FIG. 17 is a flowchart illustrating the operation of an electronic device according to an embodiment of the disclosure.

### [Mode for Carrying out the Invention]

Hereinafter, embodiments of the disclosure will be described in detail with reference to the drawings such that a person ordinarily skilled in the art to which the disclosure belongs can easily carry out the disclosure. However, the disclosure may be implemented in many different forms, and is not limited to the embodiments described herein. In connection with a description made with reference to the drawings, the same or similar reference numerals may be used for the same or similar elements. In addition, in the drawings and related descriptions, descriptions of well-known functions and configurations may be omitted for clarity and brevity.

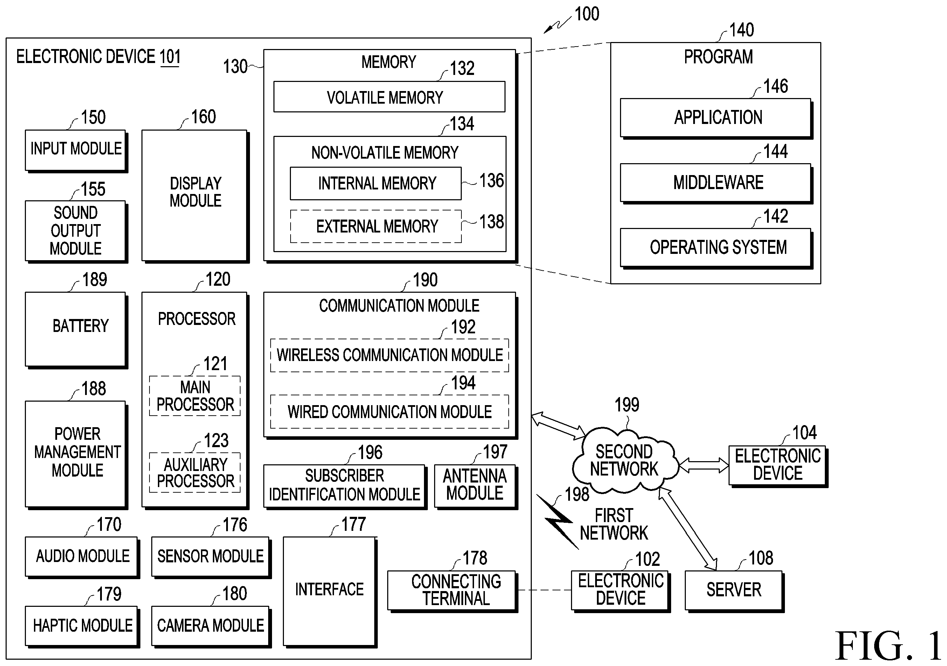

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

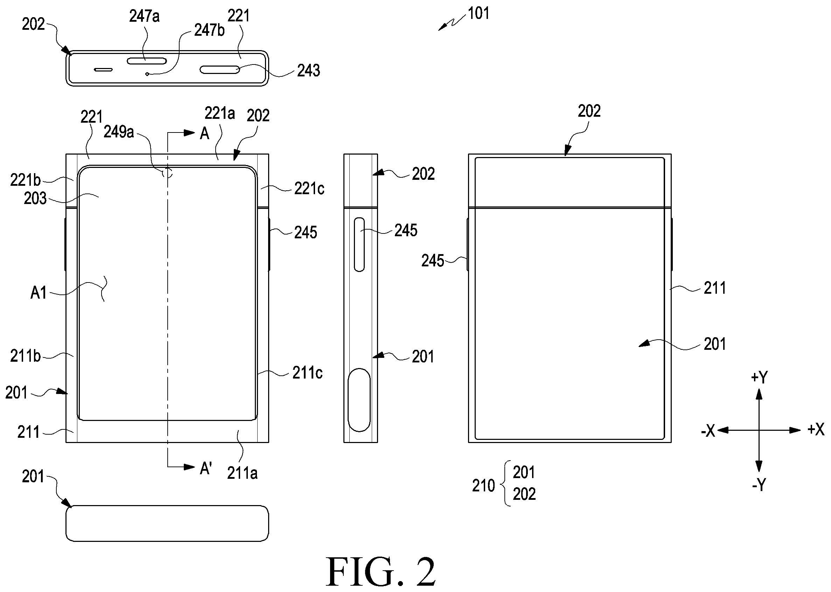

FIG. 2 is a view illustrating the state in which a second display area of a display according to an embodiment of the disclosure is accommodated in a housing.

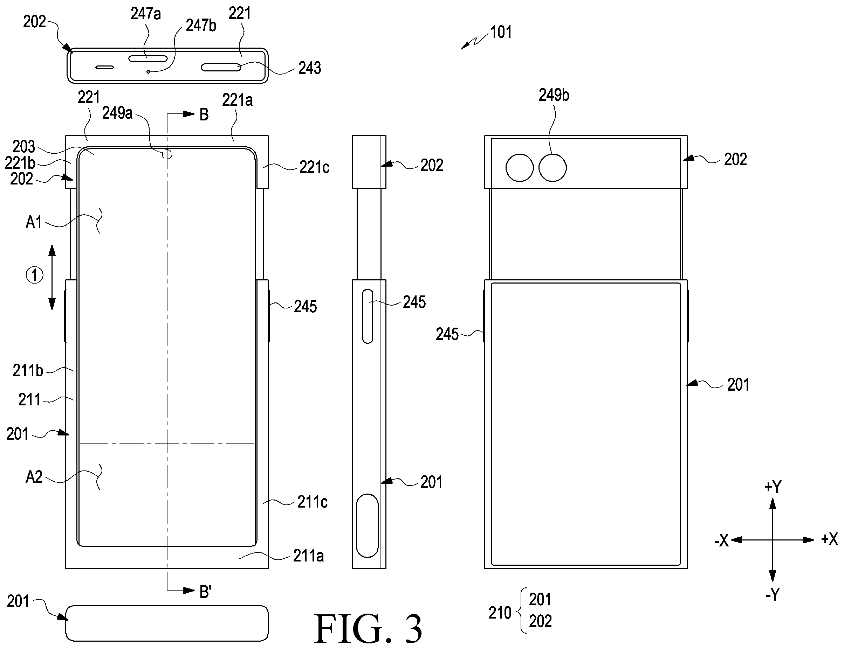

FIG. 3 is a view illustrating the state in which the second display area of the display according to an embodiment of the disclosure is exposed to the exterior the housing.

FIGS. 2 and 3 illustrate a structure in which a display 203 (e.g., a flexible display or rollable display) is expanded in the longitudinal direction (e.g., the +Y direction) when viewed from the front of the electronic device 101. However, the expansion direction of the display 203 is not limited to one direction (e.g., the +Y direction). For example, a design change may be made such that the display 203 can be expanded upward (e.g., in the +Y direction), rightward (e.g., in the +X direction), leftward (e.g., in the -X direction), and/or downward (e.g., in the -Y direction).

The state illustrated in FIG. 2 may be referred to as a slid-in state of the electronic device 101 or a state in which the second display area A2 of the display 203 is closed.

The state illustrated in FIG. 3 may be referred to as a slid-out state of the electronic device 101 or a state in which the second display area A2 of the display 203 is opened.

Referring to FIGS. 2 and 3, the electronic device 101 may include a housing 210. The housing 210 may include a first housing 201 and a second housing 202 disposed to be movable relative to the first housing 201. In an embodiment, the electronic device 101 may be interpreted as having a structure in which the first housing 201 is disposed to be slidable relative to the second housing 202. According to an embodiment, the second housing 202 may be disposed to be reciprocable by a predetermined distance in the illustrated direction (e.g., the direction indicated by arrow ①) with respect to the first housing 201.

According to an embodiment, the second housing 202 may be referred to as a slide portion or a slide housing and may be movable relative to the first housing 201. According to an embodiment, the second housing 202 may accommodate various electrical and electronic components such as a circuit board and a battery.

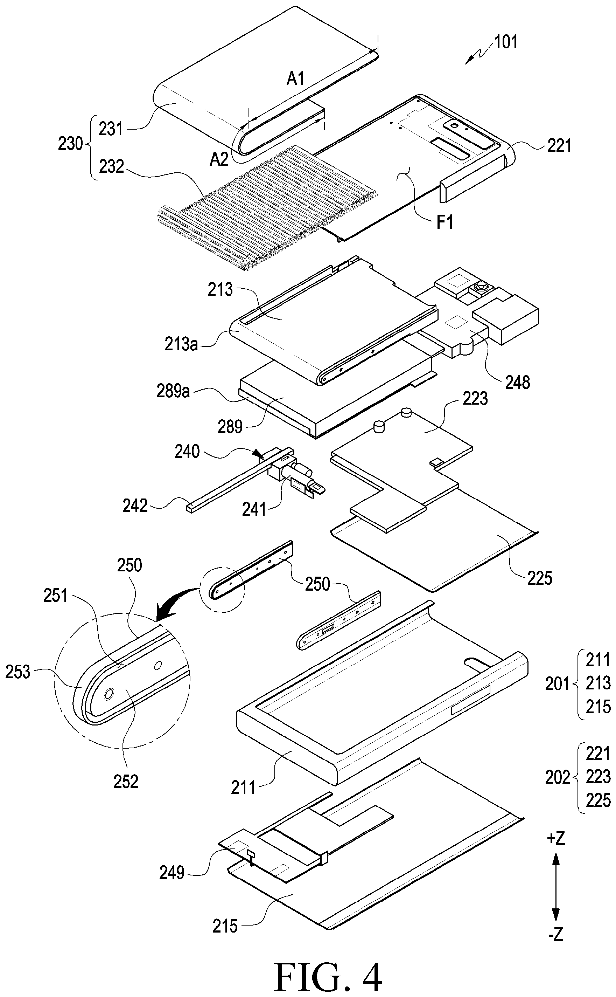

According to an embodiment, the first housing 201 may accommodate a motor, a speaker, a SIM socket, and/or a sub-circuit board (e.g., the second circuit board 249 in FIG. 4) electrically connected to the main circuit board. The second housing 202 may accommodate a main circuit board (e.g., the first circuit board 248 in FIG. 4) on which electrical components such as an application processor (AP) and a communication processor (CP) are mounted.

According to an embodiment, the first housing 201 may include a first cover member 211. The first cover member 211 may include a (1-1)^{th} side wall 211a, a (1-2)^{th} side wall 211b extending from the (1-1)^{th} side wall 211a, and a (1-3)^{th} side wall 211a extending from the (1-1)^{th} side wall 211c substantially parallel to the (1-2)^{th} side wall 211b. According to an embodiment, the (1-2)^{th} side wall 211b and the (1-3)^{th} side wall 211c may be substantially perpendicular to the (1-1)^{th} side wall 211a. According to an embodiment, the first cover member 211 may be referred to as a main case or a cover member.

According to an embodiment, the (1-1)^{th} side wall 211a, the (1-2)^{th} side wall 211b, and the (1-3)^{th} side wall 211c of the first cover member 211 may have a shape that is open on one side (e.g., the front surface) to accommodate (or surround) at least a portion of the second housing 202. For example, at least a portion of the second housing 202 may be surrounded by the first housing 201 and may be slid in a direction parallel to a first surface (e.g., the first surface F1 in FIG. 4) (e.g., the direction indicated by arrow ①) while being guided by the first housing 201. According to an embodiment, the (1-1)^{th} side wall 211a, the (1-2)^{th} side wall 211b, and/or the (1-3)^{th} side wall 211c of the first cover member 211 may be integrally configured. According to an embodiment, the (1-1)^{th} side wall 211a, the (1-2)^{th} side wall 211b, and/or the (1-3)^{th} side wall 211c of the first cover member 211 may be provided as separate structures and coupled or assembled to each other.

According to an embodiment, the first cover member 211 may be configured to surround at least a portion of a display 203. For example, the display 203 may be provided to be at least partially surrounded by the (1-1)^{th} side wall 211a, the (1-2)^{th} side wall 211b, and/or the (1-3)^{th} side wall 211c of the first cover member 211.

According to an embodiment, the second housing 202 may include a second cover member 221 (e.g., a slide plate). The second cover member 221 may have a plate shape and include a first surface (e.g., the first surface F1 in FIG. 4) supporting internal components. For example, the second cover member 221 may support at least a portion of the display 203 (e.g., the first display area A1). According to an embodiment, the second cover member 221 may be referred to as a front cover.

According to an embodiment, the second cover member 221 may include a (2-1)^{th} side wall 221a, a (2-2)^{th} side wall 221b extending from the (2-1)^{th} side wall 221a, and a (2-3)^{th} side wall 221c extending from the (2-1)^{th} side wall 221a substantially parallel to the (2-2)^{th} side wall 221b. According to an embodiment, the (2-2)^{th} side wall 221b and the (2-3)^{th} side wall 221c may be substantially perpendicular to the (2-1)^{th} side wall 221a. According to an embodiment, the second cover member 221 may be referred to as an auxiliary cover member.

According to an embodiment, as the second housing 202 moves in the first direction (e.g., direction ①) parallel to the (2-2)^{th} side wall 211b or the (2-3)^{th} side wall 211c, the electronic device 101 may be in the slid-in state and the slid-out state. In the slid-in state of the electronic device 101, the second housing 202 is positioned at a first distance from the (1-1)^{th} side wall 211a of the first housing 201, and in the slid-out state of the electronic device 101, the second housing 202 may be moved to be positioned at a second distance greater than the first distance from the (1-1)^{th} side wall 211a of the first housing 201. In an embodiment, in the slid-in state of the electronic device 101, the first housing 201 may be configured to partially surround the (2-2)^{th} side wall 221b and the (2-3)^{th} side wall 221c.

According to an embodiment, the electronic device 101 may be in an intermediate state between the slid-in state of FIG. 2 (e.g., the fully closed state) and the slid-out state of FIG. 3 (e.g., the fully opened state). The distance between the (1-1)^{th} side wall 211a and the (2-1)^{th} side wall 221a in the intermediate state of the electronic device 101 may be smaller than the distance between the (1-1)^{th} side wall 211a and the (2-1)^{th} side wall 211a of the electronic device 101 in the fully opened state and may be greater than the distance between the (1-1)^{th} side wall 211a and the (2-1)^{th} side wall 221a of the electronic device 101 in the fully closed state.

According to an embodiment, as at least a portion of the display 203 slides in the intermediate state of the electronic device 101, the area of the display exposed to the outside may be variable. For example, in the intermediate state of the electronic device 101, the ratio of the width (the length in the X direction) and the height (the length in the Y direction) of the display 203 and/or the distance between the (1-1)^{th} side wall 211a and the (2-1)^{th} side wall 221a may be changed based on the slide movement of the electronic device 101.

According to an embodiment, the electronic device 101 may include a display 203, a key input device 245, a connector hole 243, audio modules 247a and 247b, or camera modules 249a and 249b. According to an embodiment, the electronic device 101 may further include an indicator (e.g., an LED device) or various sensor modules.

According to an embodiment, the display 203 may include a first display area A1 and a second display area A2 configured to be exposed to the exterior the electronic device 101 based on the slide movement of and the second housing 202. According to an embodiment, the first display area A1 may be disposed on the second housing 202. For example, the first display area A1 may be disposed on the second cover member 221 of the second housing 202. According to an embodiment, the second display area A2 extends from the first display area A1, and as the second housing 202 slides relative to the first housing 201, the second display area A2 may be accommodated inside the first housing 201 or visually exposed to the exterior of the electronic device 101. According to an embodiment, as the electronic device 101 is changed from the slid-in state to the slid-out state, the display 203 may be expanded in the downward direction of the electronic device 101 (e.g., the -Y direction). For example, when the electronic device 101 is in the slid-out state, the second display area A2 may be visually exposed below the display 203 (e.g., in the -Y direction). According to an embodiment, as the electronic device 101 is changed from the slid-in state to the slid-out state, the display 203 may be expanded in the upward direction of the electronic device 101 (e.g., in the +Y direction). For example, when the electronic device 101 is in the slid-out state, the second display area A2 may be visually exposed above the display 203 (e.g., in the +Y direction).

According to an embodiment, the second display area A2 may move substantially while being guided by an area of the first housing 201 (e.g., the curved surface 213a in FIG. 4), and may be accommodated in a space positioned inside the first housing 201 or exposed to the exterior of the electronic device 101. According to an embodiment, the second display area A2 may be moved based on the sliding of the second housing 202 in the first direction (e.g., the direction indicated by arrow ①). For example, while the second housing 202 slides, a portion of the second display area A2 may be deformed into a curved shape at a position corresponding to the curved surface 213a of the first housing 201.

According to an embodiment, when viewed from above the second cover member 221 (e.g., the front cover), when the electronic device 101 is changed from the slid-in state to the slid-out state (for example, when the second housing 202 slides to be expanded with respect to the first housing 201), the second display area A2 may form a substantially flat surface together with the first display area A1 while being gradually exposed to the exterior of the first housing 201. According to an embodiment, the display 203 may be coupled to or arranged adjacent to a touch-sensing circuit, a pressure sensor that is capable of measuring touch intensity (pressure), and/or a digitizer that detects a magnetic field-type stylus pen. According to an embodiment, regardless whether the electronic device 101 is in the slid-in or slid-out state, a portion of the second display area A2 may be positioned on a portion of the first housing (e.g., the curved surface 213a in FIG. 4), and a portion of the second display area A2 may maintain the curved shape at a position corresponding to the curved surface 213a.

According to an embodiment, the key input device 245 may be positioned in one area of the housing 210 (e.g., the first housing 201 and/or the second housing 202). Depending on the external appearance and use state, the electronic device 101 may be designed such that the illustrated key input devices 245 are omitted or one or more additional key input devices are included. According to an embodiment, the electronic device 101 may include key input devices (not illustrated), such as a home key button or touch pads arranged around the home key button. According to an embodiment, at least some of the key input devices 245 may be disposed on the (1-1)^{th} side wall 211a, the (1-2)^{th} side wall 211b, or the (1-3)^{th} side wall 211c of the first housing 201. According to an embodiment, at least some of the key input devices 245 may be disposed on the (2-1)^{th} side wall 221a, the (2-2)^{th} side wall 221b, and/or the (2-3)^{th} side wall 221c of the second housing 202.

According to an embodiment, the connector hole 243 may be omitted in some embodiments and may accommodate a connector (e.g., a USB connector) for transmitting/receiving power and/or data to/from an external electronic device. According to an embodiment (not illustrated), the electronic device 101 may include a plurality of connector holes 243, and some of the connector holes 243 may function as connector holes for transmitting/receiving audio signals to/from an external electronic device. In the illustrated embodiment, the connector hole 243 is positioned in the second housing 202, but is not limited to thereto. The connector hole 243 or a connector hole (not illustrated) may be positioned in the first housing 201.

According to an embodiment, the audio modules 247a and 247b may include one or more speaker holes 247a or one or more microphone holes 247b. One of the speaker holes 247a may be provided as a receiver hole for a voice call, and another one may be provided as an external speaker hole. The electronic device 101 may include a microphone configured to acquire sound, and the microphone may acquire sound outside the electronic device 101 through the microphone holes 247b. According to an embodiment, the electronic device 101 may include a plurality of microphones to detect the direction of sound. According to an embodiment, the electronic device 101 may include an audio module in which the speaker holes 247a and the microphone holes 247b are implemented as a single hole, or a speaker in which the speaker holes 247a are excluded (e.g., a piezo speaker). According to an embodiment, the speaker hole 247a and the microphone hole 247b may be positioned in the first housing 201 and/or the second housing 202.

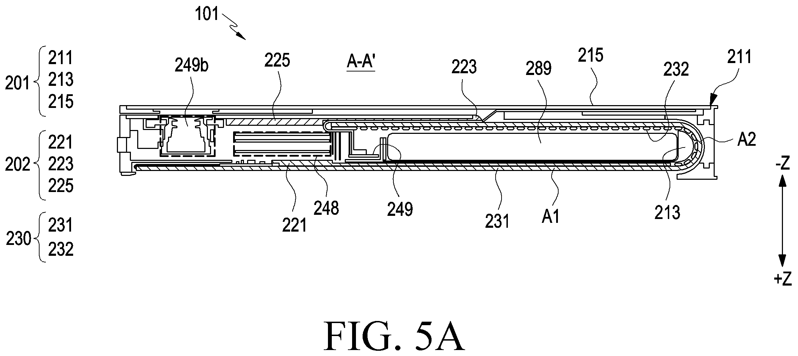

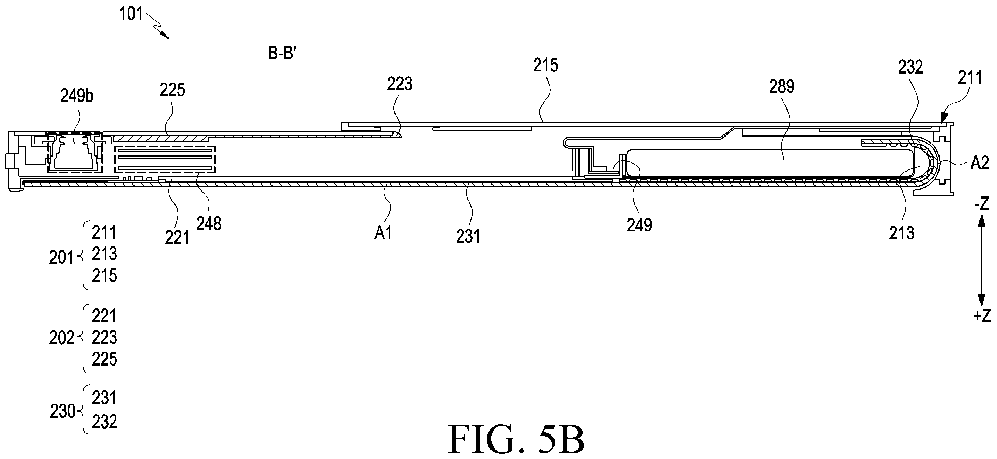

According to an embodiment, the camera modules 249a and 249b may include a first camera module 249a (e.g., a front camera) and a second camera module 249b (e.g., a rear camera) (e.g., the second camera module 249b in FIGS. 5A and 5B). According to an embodiment, the electronic device 101 may include at least one of a wide-angle camera, a telephoto camera, or a close-up camera. In some embodiments, the electronic device 101 may include an infrared projector and/or an infrared receiver to measure the distance to a subject. The camera modules 249a and 249b may include one or more lenses, an image sensor, and/or an image signal processor. The first camera module 249a may be disposed to be oriented in the same direction as the display 203. For example, the first camera module 249a may be arranged around the first display area A1 or in an area overlapping the display 203, and may capture a subject through the display 203 when arranged in the area overlapping the display 203. According to an embodiment, the first camera module 249a may include an under-display camera (UDC) which may be hidden without being visually exposed to a screen display area (e.g., the first display area A1). According to an embodiment, the second camera module 249b may capture a subject in a direction substantially opposite to the first display area A1. According to an embodiment, the first camera module 249a and/or the second camera module 249b may be disposed on the second housing 202. According to an embodiment, a plurality of second camera module 249b may be provided to provide various arrangements. For example, the plurality of second camera modules 249b may be arranged along the width direction (the X-axis direction), which is a direction substantially perpendicular to the slide movement direction (e.g., the Y-axis direction) of the electronic device 101. As another example, the plurality of second camera modules 249b may be arranged along the slide movement direction (e.g., the Y-axis direction) of the electronic device 101. As another example, the plurality of second camera modules 249b may be arranged along N * M rows and columns like a matrix.

According to an embodiment, when the electronic device 101 is in the slid-in state, the second camera module 249b may not be visually exposed to the outside of the electronic device 101, and when the electronic device 101 is in the slid-out state, the second camera module 249b may capture a scene outside the electronic device 101. According to an embodiment, the second camera module 249b may capture a scene outside the electronic device 101 when the electronic device 101 is in the slid-in state and the slid-out state. For example, at least a portion of the housing 210 (e.g., the first rear surface plate 215 and/or the second rear surface plate 225 in FIG. 4) may be substantially transparent, and the second camera module 249b may capture a scene outside the electronic device 101 through the first rear surface plate 215 and/or the second rear surface plate 225.

According to an embodiment, an indicator (not illustrated) of the electronic device 101 may be disposed on the first housing 201 or the second housing 202, and may include a light-emitting diode to provide state information of the electronic device 101 as a visual signal. A sensor module (not illustrated) of the electronic device 101 may generate an electrical signal or a data value corresponding to an internal operating status of the electronic device 101 or an external environmental status. The sensor module may include, for example, a proximity sensor, a fingerprint sensor, or a biometric sensor (e.g., an iris/face recognition sensor or a heart rate monitor (HRM) sensor). In another embodiment, the sensor modules may further include at least one of, for example, a gesture sensor, a gyro sensor, an atmospheric pressure sensor, a magnetic sensor, an acceleration sensor, a grip sensor, a color sensor, an infrared (IR) sensor, a temperature sensor, a humidity sensor, or an illuminance sensor. According to an embodiment, the sensor modules may be disposed in the first housing 201 and the second housing 202. For example, at least some of the sensor modules may be positioned in the first housing 201, while some others may be positioned in the second housing 202.

FIG. 4 is an exploded perspective view of an electronic device according to an embodiment of the disclosure.

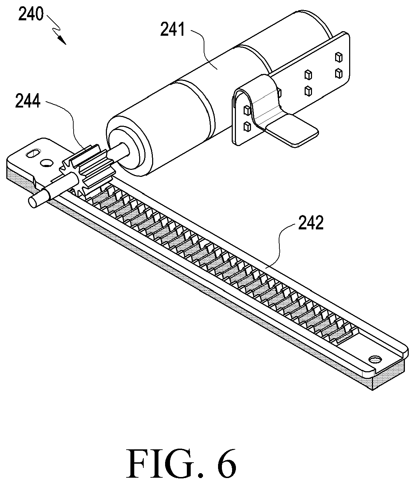

FIG. 5A is a cross-sectional view of an embodiment of the disclosure, taken along line A-A' in FIG. 2. FIG. 5B is a cross-sectional view of an embodiment of the disclosure, taken along line B-B' in FIG. 3. FIG. 6 is a perspective view of a driving structure according to an embodiment of the disclosure.

Referring to FIG. 4, FIG. 5A, FIG. 5B, and/or FIG. 6, the electronic device 101 may include a first housing 201, a second housing 202, a display assembly 230, and a driving structure 240. The components of the first housing 201, the second housing 202, and the display assembly 230 of FIG. 4, FIG. 5A and/or FIG. 5B may be wholly or partially the same as those of the first housing 201, the second housing 202, and the display 203 of FIG. 2 and/or FIG. 3. The embodiment illustrated in FIG. 2 and/or FIG. 3 may be partially combined with the embodiments illustrated in FIG. 4, FIG. 5A, FIG. 5B, and/or FIG. 6. According to an embodiment, the first housing 201 may include a first cover member 211 (e.g., the first cover member 211 in FIGS. 2 and 3), a frame 213, and a first rear surface plate 215.

According to an embodiment, the first cover member 211 may accommodate at least a portion of the frame 213 and a component (e.g., the battery 289) positioned on the frame 213. According to an embodiment, the first cover member 211 may be configured to surround at least a portion of a second housing 202. According to an embodiment, the first cover member 211 may protect components (e.g., the second circuit board 249 and the frame 213) positioned in the first housing 201 from external impact. According to an embodiment, the second circuit board 249, which accommodates electronic components, may be connected to the first cover member 211.

According to an embodiment, the frame 213 may be connected to the first cover member 211. For example, the frame 213 may be connected to the first cover member 211, and the second housing 202 may be moved relative to the first cover member 211 and/or the frame 213. According to an embodiment, the frame 213 may accommodate the battery 289. For example, the frame 213 may include a groove to accommodate the battery 289. The frame 213 may be connected to a battery cover 289a and may surround at least a portion of the battery 289 together with the battery cover 289a. According to an embodiment, the frame 213 may include a curved portion 213a facing the display assembly 230.

According to an embodiment, the first rear surface plate 215 may substantially define at least a portion of the exterior of the first housing 201 or the electronic device 101. For example, the first rear surface plate 215 may be coupled to the outer surface of the first cover member 211. According to an embodiment, the first rear surface plate 215 may provide a decorative effect on the exterior of the electronic device 101. The first rear surface plate 215 may be made of at least one of metal, glass, synthetic resin, or ceramic.

According to an embodiment, the second housing 202 may include a second cover member 221 (e.g., the second cover member 221 in FIGS. 2 and 3), a rear cover 223, and a second rear surface plate 225.

According to an embodiment, the second cover member 221 may be connected to the first housing 201 via a guide rail 250, and may linearly reciprocate in in one direction (e.g., the direction indicated by arrow ① in FIG. 3) while being guided by the guide rail 250.

According to certain embodiments, the second cover member 221 may support at least a portion of the display 231 (e.g., the display 203 in FIG. 2 and/or FIG. 3). For example, the second cover member 221 may include a first surface F1, and the first display area A1 of the display 231 may be substantially positioned on the first surface F1 and maintained in a flat plate shape. According to an embodiment, the second cover member 221 may be made of a metal material and/or a non-metal (e.g., polymer) material. According to an embodiment, the first circuit board 248, which accommodates electronic components (e.g., the processor 120 and/or the memory 130 in FIG. 1), may be connected to the second cover member 221. According to an embodiment, the second cover member 221 may protect components (e.g., the first circuit board 248 and the rear cover 223) positioned in the second housing 202 from external impact.

According to an embodiment, the rear cover 223 may protect components (e.g., the first circuit board 248) positioned on the second cover member 221. For example, the rear cover 223 may be connected to the second cover member 221 and surround at least a portion of the first circuit board 248. According to an embodiment, the rear cover 223 may include an antenna pattern for communication with an external electronic device. For example, the rear cover 223 may include a laser direct structuring (LDS) antenna.

According to an embodiment, the second rear surface plate 225 may substantially define at least a portion of the exterior of the second housing 202 or the electronic device 101. For example, the second rear surface plate 225 may be coupled to the outer surface of the second cover member 221. According to an embodiment, the second rear surface plate 225 may provide a decorative effect on the exterior of the electronic device 101. The second rear surface plate 225 may be made of at least one of metal, glass, synthetic resin, or ceramic.

According to an embodiment, the display assembly 230 may include a display 231 (e.g., display 203 in FIGS. 2 and/or 3) and a multi-bar structure 232 supporting the display 231. According to an embodiment, the display 231 may be referred to as a flexible display, a foldable display, and/or a rollable display. According to an embodiment, the first display area A1 of the display 231 may be supported by a rigid body, and the second display area A2 may be supported by a bendable structure. For example, the first display area A1 may be supported by the first surface F1 of the second cover member 221 or a plate (not illustrated). The second display area A2 may be supported by the multi-bar structure 232.

According to an embodiment, the multi-bar structure 232 may be connected or attached to at least a portion of the display 231 (e.g., the second display area A2). According to an embodiment, as the second housing 202 slides, the multi-bar structure 232 may move relative to the first housing 201. When the electronic device 101 is in the slid-in state (e.g., FIG. 2), the multi-bar structure 232 may be mostly accommodated inside the first housing 201, and may be positioned between the first cover member 211 and the second cover member 221. According to an embodiment, at least a portion of the multi-bar structure 232 may move to correspond to the curved surface 213a positioned at an edge of the frame 213. According to an embodiment, the multi-bar structure 232 may be referred to as a display support member or support structure, and may be in the form of an elastic plate.

According to an embodiment, the driving structure 240 may relatively move the second housing 202 relative to the first housing 201. For example, the driving structure 240 may include a motor 241 configured to generate a driving force for sliding the second housing 202 relative to the first housing 201. The driving structure 240 may include a gear 244 (e.g., a pinion) connected to the motor 241 and a rack 242 configured to be engaged with the gear.

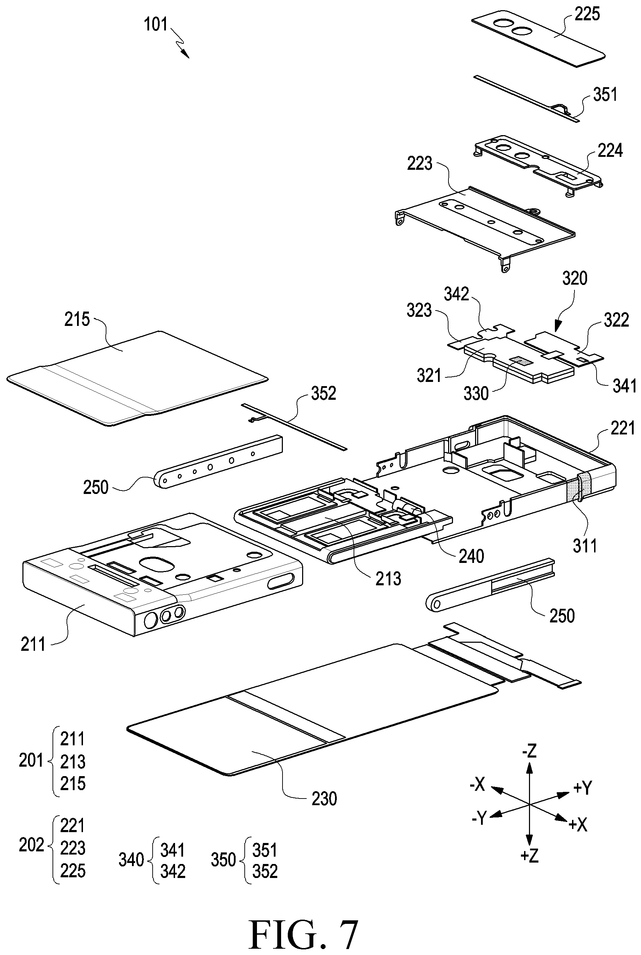

According to an embodiment, the housing in which the rack 242 is positioned and the housing in which the motor 241 is positioned may be different. According to an embodiment, the motor 241 may be connected to the second housing 202, and the rack 242 may be connected to the first housing 201. According to an embodiment (e.g., FIG. 7), the motor 241 may be connected to the first housing 201, and the rack 242 may be connected to the second housing 202 (e.g., the second cover member 221). For example, the motor 241 may be mounted on the frame 213.

According to an embodiment, the motor 241 may be controlled by a processor (e.g., the processor 120 in FIG. 1). For example, the processor 120 may include a motor driver driving circuit and deliver a pulse width modulation (PWM) signal to the motor 241 to control the speed of the motor 241 and/or the torque of the motor 241. According to an embodiment, the motor 241 may be electrically connected to a processor (e.g., the processor 120 in FIG. 1) positioned on a circuit board (e.g., the first circuit board 248 or the second circuit board 249 in FIG. 4) via a flexible printed circuit board.

According to an embodiment, the second housing 202 may accommodate the first circuit board 248 (e.g., a main board). According to an embodiment, a processor, memory, and/or an interface may be mounted on the first circuit board 248. The processor may include, for example, one or more of a central processing unit, an application processor, a graphics processing unit, an image signal processor, a sensor hub processor, or a communication processor. According to various embodiments, the first circuit board 248 may include a flexible printed circuit board-type radio frequency cable (FRC). The first circuit board 248 may be disposed in at least a portion of the second cover member 221 and may be electrically connected to an antenna module and a communication module.

According to an embodiment, the memory may include, for example, volatile memory or nonvolatile memory.

According to an embodiment, the interface may include, for example, a high-definition multimedia interface (HDMI), a universal serial bus (USB) interface, an SD card interface, and/or an audio interface. For example, the interface may electrically or physically connect the electronic device 101 to an external electronic device, and include a USB connector, an SD card/MMC connector, or an audio connector.

According to an embodiment, the electronic device 101 may include a second circuit board 249 (e.g., a sub-circuit board) spaced apart from the first circuit board 248 (e.g., a main circuit board) within the first housing 201. The second circuit board 249 may be electrically connected to the first circuit board 248 via a connection flexible board. The second circuit board 249 may be electrically connected to the battery 289 or electrical components disposed in an end area of the electronic device 101, such as a speaker and/or a SIM socket, to transmit signals and power. According to an embodiment, the second circuit board 249 may accommodate or be connected to a wireless charging antenna (e.g., a coil). For example, the battery 289 may receive power from an external electronic device using the wireless charging antenna. As another example, the battery 289 may transmit power to an external electronic device using the wireless charging antenna.

According to an embodiment, the battery 289 is a device that supplies power to at least one component of the electronic device 101, and may include a non-rechargeable primary battery, a rechargeable secondary battery, or a fuel cell. The battery 289 may be integrally disposed inside the electronic device 101 or may be detachably disposed on the electronic device 101. According to an embodiment, the battery 289 may be configured as a single integrated battery or may include a plurality of separable batteries. According to an embodiment, the battery 289 may be positioned on the frame 213. For example, the battery 289 may be surrounded by the frame 213 and the battery cover 289a. According to another embodiment, the battery may be positioned within the second housing 202 to be slidable with the second housing 202.

According to an embodiment, the guide rail 250 may guide the movement of the multi-bar structure 232. For example, the multi-bar structure 232 may slide along the slit 251 provided in the guide rail 250. According to an embodiment, the guide rail 250 may be connected to the first housing 201. For example, the guide rail 250 may be connected to the first cover member 211 and/or the frame 213. According to an embodiment, the slit 251 may be referred to as a groove or recess provided on the inner surface of the guide rail 250.

According to an embodiment, the guide rail 250 may provide a force to the multi-bar structure 232 based on the driving of the motor 241.

According to an embodiment, when the electronic device 101 is changed from the slid-in state to the slid-out state, the inner portion 252 of the guide rail 250 may provide a force to the multi-bar structure 232. The multi-bar structure 232, which has received the force, may move along the slit 251 of the guide rail 250, and the second housing 202 may slide to be expanded with respect to the first housing 201. At least a portion of the display assembly 230 accommodated between the first cover member 211 and the frame 213 may be expanded to the front surface.

According to an embodiment, when the electronic device 101 is changed from the slid-out state to the slid-in state, the outer portion 253 of the guide rail 250 may provide a force to the bent multi-bar structure 232. The multi-bar structure 232, which has received the force, may move along the slit 251 of the guide rail 250, and the second housing 202 may slide to be at least partially accommodated in the first housing 201. At least a portion of the display assembly 230 may be accommodated between the first cover member 211 and the frame 213.

Referring to FIG. 5A, when the electronic device 101 is in the slid-in state, at least a portion of the second housing 202 may be disposed to be accommodated in the first housing 201. As the second housing 202 is disposed to be accommodated in the first housing 201, the overall volume of the electronic device 101 may be reduced. According to an embodiment, when the second housing 202 is accommodated in the first housing 201, the visually exposed size of the display 231 may be minimized. For example, when the second housing 202 is fully accommodated in the first housing 201, the first display area A1 of the display 231 is visually exposed, and at least a portion of the second display area A2 (e.g., the portion oriented in the -Z axis direction) may be disposed between the battery 289 and the first rear surface plate 215.

Referring to FIG. 5B, when the electronic device 101 is in the slid-out state, at least a portion of the second housing 202 may be disposed to protrude from the first housing 201. As the second housing 202 protrudes from the first housing 201, the overall volume of the electronic device 101 may be reduced. According to an embodiment, when the second housing 202 protrudes from the first housing 201, at least a portion of the second display area A2 of the display 231 may be visually exposed to the exterior the electronic device 101 together with the first display area A1.

FIG. 7 is an exploded perspective view of an electronic device according to an embodiment of the disclosure. For example, FIG. 7 is a rear exploded perspective view of an electronic device 101 according to an embodiment.

Referring to FIG. 7, the electronic device 101 may include a first housing 201, a second housing 202, a display assembly 230, a driving structure 240, a connection member 340, and a touch sensor 350. The configurations of the first housing 201, the second housing 202, the display assembly 230, and the driving structure 240 of FIG. 7 may be wholly or partially the same as the configurations of the first housing 201, the second housing 202, the display assembly 230, and the driving structure 240 of FIG. 4.

According to an embodiment, the electronic device 101 may include a circuit board 320. The circuit board 320 may accommodate components of the electronic device 101 (e.g., the processor 120 and/or the sensing circuit 330 in FIG. 1). According to an embodiment, the circuit board 320 may be positioned within the second housing 202. For example, the circuit board 320 may be disposed on the second cover member 221.

According to an embodiment, the circuit board 320 (e.g., the first circuit board 248 in FIG. 4) may include a plurality of boards. For example, the circuit board 320 may include a first board 321, a second board 322, and a third board 323. The first board 321 may accommodate the processor 120 and/or the sensing circuit 330. The first board 321 may be referred to as a main board. The second board 322 may accommodate some of the connection members 340. For example, a first connection member 341 may be disposed on the second board 322. The second board 322 may be referred to as a sub-board. The third board 323 may accommodate other some of the connection members 340. For example, a second connection member 342 may be disposed on the third board 323. The third board 323 may be referred to as a subscriber identification module (SIM) board.

According to an embodiment, the electronic device 101 may include a sensing circuit 330. The sensing circuit 330 may detect and/or determine contact of a user's body with the electronic device 101. The sensing circuit 330 may be referred to as a sensing integrated circuit.

In an embodiment, the sensing circuit 330 may include a grip sensor and may detect an electrical signal (e.g., a change in dielectric constant) passing through the connection members 340. For example, the sensing circuit 330 may detect a change in dielectric constant that changes as the user's body grips the electronic device 101. For example, when the user's body (e.g., a finger) comes into contact with a portion of the first housing 201 and/or the second housing 202 connected to the connection member 340 (e.g., the metal area 311 in the second cover member 221), the capacitance detected by the sensing circuit 330 may change. The sensing circuit 330 may determine whether the user's body has come into contact with a predetermined position (e.g., the metal area 311) based on the difference between the capacitance before the contact and the capacitance after the contact.

In an embodiment, the sensing circuit 330 may detect or determine the contact of the user's body with the electronic device 101 using the touch sensor 350. The sensing circuit 330 may determine whether the user's body has come into contact and/or the contact position based on the electrostatic capacity detected by the touch sensor 350.

In an embodiment, the sensing circuit 330 may be a separate circuit from the processor (e.g., the processor 120 in FIG. 1). In an embodiment, the sensing circuit 330 may be a circuit included in the processor (e.g., the processor 120 in FIG. 1).

According to an embodiment, the electronic device 101 may include connection members 340. The connection members 340 may detect user input provided outside the electronic device 101. For example, the connection members 340 may be positioned within at least a portion of the housing 210 (e.g., the second cover member 221) and may be disposed to be in contact with the circuit board 320 and the metal area 311 of the second cover member 221.

According to an embodiment, the connection members 340 may transmit electrical signals generated based on the user contact with the electronic device 101 to the sensing circuit 330. For example, the connection members 340 may electrically connect the sensing circuit 330 and the metal area 311 of the second cover member 221.

According to an embodiment, the connection members 340 may include a plurality of connection members 341 and 342 for the side surfaces of the electronic device 101. The connection members 340 may include a first connection member 341 and a second connection member 342. The first connection member 341 may face a different direction (e.g., the opposite direction) from the second connection member 342. For example, the first connection member 341 may be in contact with the left side of the metal area 311 of the electronic device 101, and the second connection member 342 may be in contact with the right side of the metal area 311 of the electronic device 101. In an embodiment, the first connection member 341 may be mounted on the second board 322. The second connection member 342 may be mounted on the third board 323. The position of the board 320 where the connection members 340 are positioned may be changed depending on the design of the electronic device 101.

According to an embodiment, the touch sensor 350 may detect the contact of the user's body (e.g., a finger) with the electronic device 101. For example, the touch sensor 350 may detect a capacitance changed by the user's body (e.g., a finger). According to an embodiment, the touch sensor 350 may detect the user's finger positioned at the rear of the electronic device 101 (e.g., in the -Z direction).

According to an embodiment, the touch sensor 350 may detect a user's grip transmitted to a non-metallic portion (or a non-conductive portion) of the first housing 201 and/or the second housing 202. According to an embodiment, the touch sensor 350 may include a plurality of touch sensors 351 and 352. For example, the touch sensor 350 may include a first touch sensor 351 positioned within the second housing 202 and a second touch sensor 352 positioned within the first housing 201. The first touch sensor 351 may be positioned between the second rear surface plate 225 and the rear cover 223. The first touch sensor 351 may be positioned between the LDS antenna 224 and the second rear surface plate 225. The second touch sensor 352 may be disposed on the first cover member 211. The second touch sensor 352 may be positioned between the first cover member 211 and the first rear surface plate 215. Depending on the design of the electronic device 101, the second touch sensor 352 may be omitted. The first touch sensor 351 may be referred to as a touch sensor or a main touch sensor. The second touch sensor 352 may be referred to as an auxiliary touch sensor.

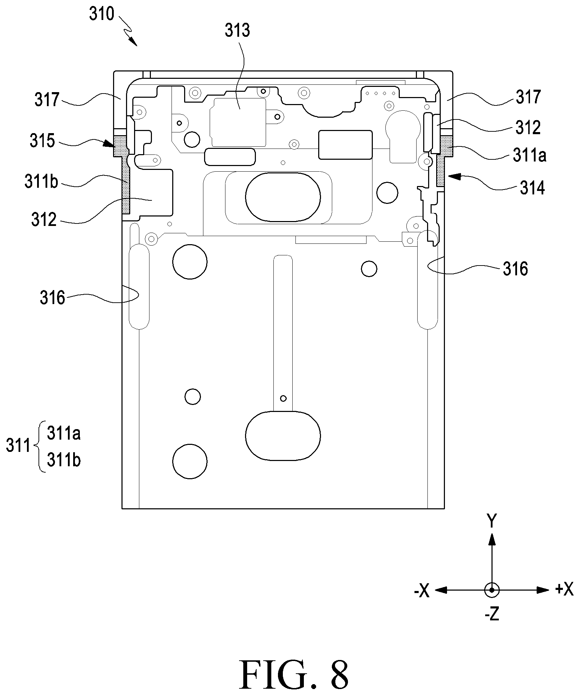

FIG. 8 is a front view illustrating a second cover member according to an embodiment of the disclosure.

Referring to FIG. 8, the second cover member 310 may include a metal area 311 and a non-metal area 312. The configuration of the second cover member 310 of FIG. 8 may be wholly or partially the same as the configuration of the second cover member 221 of FIG. 7.

According to an embodiment, the second cover member 310 may include a metal area 311, a non-metal area 312, and/or a support area 313. The metal area 311 may be at least partially surrounded by the non-metal area 312. The non-metal area 312 may be a portion of the second cover member 310 that electrically separates the metal area 311 and the support area 313. For example, the non-metal area 312 may be formed using injection molding. The non-metal area 312 may include a resin.

According to an embodiment, the metal area 311 may be electrically connected to a connection member (e.g., the connection member 340 in FIG. 7). For example, the connection member 340 may be formed at least in part of a conductive material and may be in contact with the metal area 311. In an embodiment, the metal area 311 may include a plurality of metal areas 311a and 311b spaced apart from each other. For example, the metal area 311 may include a first metal area 311a that is in contact with a first connection member (e.g., the first connection member 341 in FIG. 7) and a second metal area 311b that is in contact with a second connection member (e.g., the second connection member 342 in FIG. 7). The first metal area 311a may form at least a portion of the first side surface area 314, and the second metal area 311b may form at least a portion of the second side surface area 315.

According to an embodiment, the second cover member 310 may include a first side surface area 314 and a second side surface area 315 that is positioned substantially opposite to the first side surface area 314. The first side surface area 314 may be the left (+X) portion of the second cover member 310, and the second side surface area 315 may be the right (-X) portion of the second cover member 310.

According to an embodiment, the second cover member 310 may include a side wall 316 and a protrusion 317 extending from the side wall 316. In the slide-in state of the electronic device 101 (e.g., FIG. 2), the side wall 316 may not be visually exposed to the exterior of the electronic device 101, and the protrusion 317 may be visually exposed to the exterior of the electronic device 101. In the slide-out state of the electronic device 101 (e.g., FIG. 3), the side wall 316 and the protrusion 317 may be visually exposed to the exterior of the electronic device 101. The metal area 311 may be positioned to correspond to a portion where the user's body comes into contact with the second cover member 221 in the slide-out state of the electronic device 101. For example, the metal area 311 may form a portion of the side wall 316 and a portion of the protrusion 317.

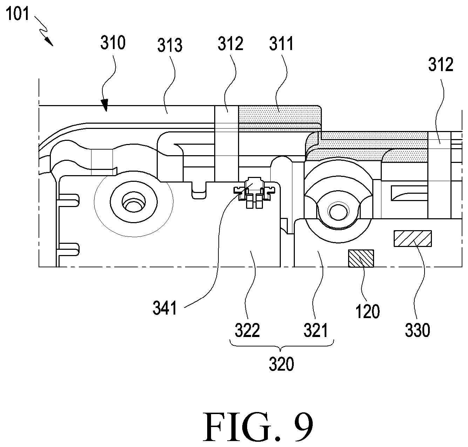

FIG. 9 is a view illustrating a structure for detecting user contact on the left side of an electronic device according to an embodiment of the disclosure.

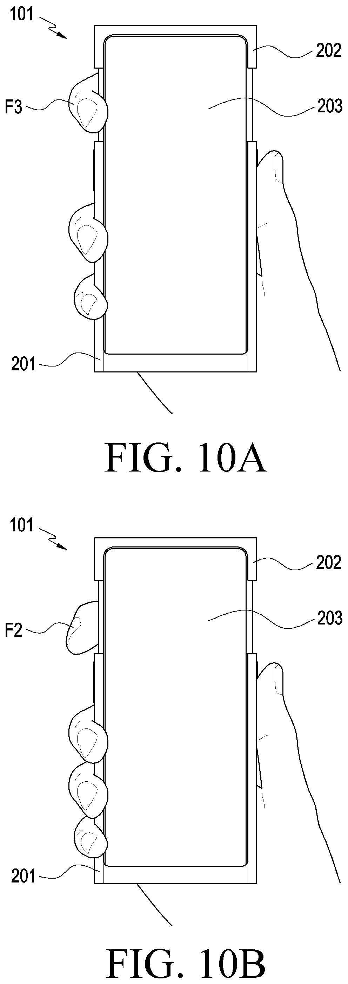

FIGS. 10A and 10B are views illustrating an operation for detecting user contact on the left side of an electronic device according to an embodiment of the disclosure.

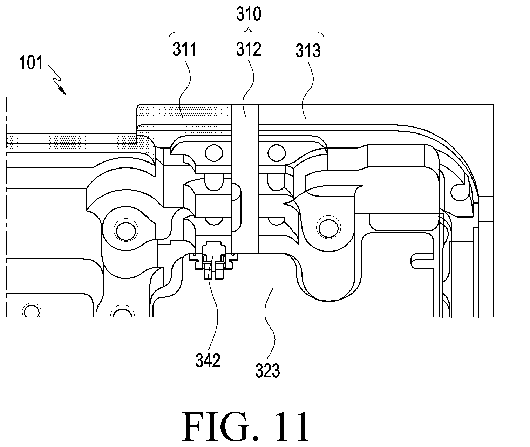

FIG. 11 is a view illustrating a structure for detecting user contact on the right side of an electronic device according to an embodiment of the disclosure.

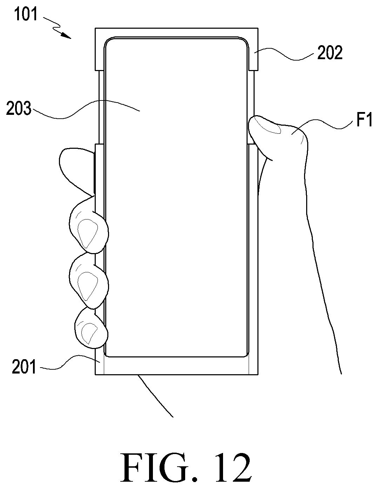

FIG. 12 is a view illustrating an operation for detecting user contact on the right side of an electronic device according to an embodiment of the disclosure.

Referring to FIG. 9, FIGS. 10A and 10B, FIG. 11, and/or FIG. 12, the electronic device 101 may include a processor 120, a second cover member 310, a circuit board 320, a sensing circuit 330, and a connection member 340. The configurations of the processor 120, the second cover member 310, the circuit board 320, the sensing circuit 330, and the connection member 340 of FIG. 9, FIGS. 10A and 10B, FIG. 11, and/or FIG. 12 may be wholly or partially the same as the configurations of the processor 120, the second cover member 310, the circuit board 320, the sensing circuit 330, and the connection member 340 of FIG. 1 and/or FIG. 7.

According to an embodiment, the sensing circuit 330 may detect the contact of the user's finger F2 or F3 with the second cover member 310 by using the connection member (e.g., the first connection member 341 and/or the second connection member 342).

Referring to FIG. 9, FIG. 10A, and/or FIG. 10B, the sensing circuit 330 may detect user contact applied to the left side of the electronic device 101. For example, the first connection member 341 may be in contact with a portion of a metal area 311 (e.g., the first metal area 311a in FIG. 8) positioned on a first side surface area (e.g., the first side surface area 314 in FIG. 8) of the second cover member 310.

When the electronic device 101 is in the slide-out state, at least a portion of the second housing (202) (e.g., the metal area 311 of the second cover member 310) may be visually exposed to the exterior of the electronic device 101. When the user's body (e.g., the index finger F2 and/or the middle finger F3) comes into contact with the metal area 311, the sensing circuit 330 may detect the capacitance changed due to the index finger F2 and/or the middle finger F3.

Referring to FIGS. 11 and 12, the sensing circuit 330 may detect user contact applied to the right side of the electronic device 101. For example, the second connection member 342 may be in contact with the metal area 311 of the second cover member 310. When the electronic device 101 is in the slide-out state, at least a portion of the second housing (202) (e.g., the metal area 310 of the second cover member 310) may be visually exposed to the exterior of the electronic device 101. When the user's body (e.g., the thumb F1) comes into contact with the metal area (e.g., the second metal area 311b) positioned on the second side area 315, the sensing circuit 330 may detect the capacitance changed due to the thumb F1. Herein, an example in which the user holds the electronic device 101 using the right hand has been described. However, this is exemplary.

According to an embodiment, the processor 120 may control the movement of the second housing 202 based on an electrical signal detected by the sensing circuit 330. For example, when a change in the capacitance is detected by the sensing circuit 330, the processor 120 may stop the second housing 202 or may cause the electronic device 101 to slide out. When a change in the capacitance is detected by the sensing circuit 330, the processor 120 may transmit a signal for stopping the slide operation of the electronic device 101 and/or a signal for slide-out of the electronic device 101 to the driving structure (e.g., the driving structure 240 in FIG. 4).

The user's body may be prevented from being pinched due to the movement (e.g., the sliding movement) of the electronic device 101. By reducing the risk of user's pinching, user convenience may be increased.

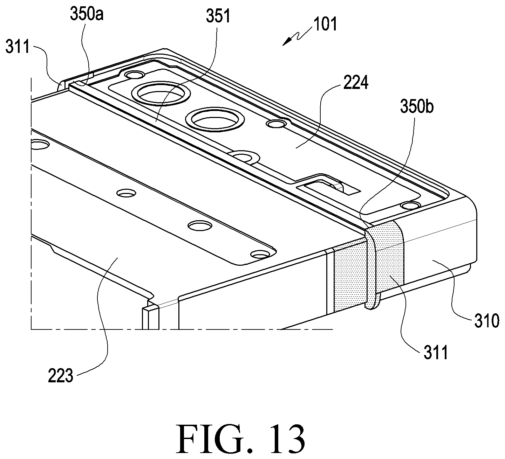

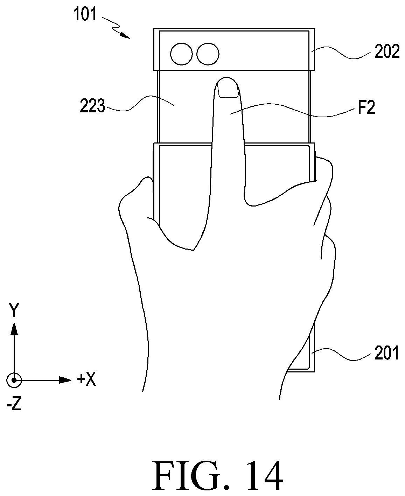

FIG. 13 is a perspective view of an electronic device including a touch sensor according to an embodiment of the disclosure. FIG. 14 is a view illustrating an operation for detecting user contact on the rear side of the electronic device according to an embodiment of the disclosure.

Referring to FIG. 13 and/or FIG. 14, an electronic device 101 may include a first housing 201, a rear cover 223, a second housing 202 including an LDS antenna 224 and a second cover member 310, a display (e.g., the display 203 in FIG. 2 and/or FIG. 3), and a first touch sensor 351. The configurations of the first housing 201, the second housing 202, the display 203, and the first touch sensor 351 of FIG. 13 and/or FIG. 14 may be wholly or partially the same as the configurations of the first housing 201, the second housing 202, the display 203, and the first touch sensor 351 of FIG. 4 and/or FIG. 7.

According to an embodiment, the electronic device 101 may include at least one memory (e.g., memory 130 in FIG. 1) storing at least one instruction. The at least one instruction, when executed by at least one processor (e.g., the processor 120 in FIG. 1), may cause the electronic device 101 to perform at least one operation (e.g., at least one of the operations performed by the electronic device 101 described in this disclosure).

According to an embodiment, the electronic device 101 may detect user contact applied to the rear side of the electronic device 101 using the first touch sensor 351. For example, the sensing circuit (e.g., the sensing circuit 330 in FIG. 7) may detect the contact of the user's finger F1 with the second housing 202 using the first touch sensor 351. For example, the first touch sensor 351of the touch sensor 350 may be positioned between and the second rear surface plate 225 and the rear cover 223. For example, the first touch sensor 351 may be positioned between the LDS antenna 224 and the second rear surface plate 225. The first touch sensor 351 may be positioned between the metal areas 311. For example, the first touch sensor 351 may include a first end 350a facing the first metal area (e.g., the first metal area 311a in FIG. 8) and a second end 350b facing the second metal area (e.g., the second metal area 311b in FIG. 8).

According to an embodiment, the processor (e.g., the processor 120 in FIG. 1) may control the movement of the second housing 202 based on an electrical signal detected by the sensing circuit 330. For example, the sensing circuit 330 may detect a change in the electrostatic capacitance detected by the first touch sensor 351. When a change in the electrostatic capacitance is detected by the sensing circuit 330, the processor 120 may stop the second housing 202 or may cause the electronic device 101 to slide out. When a change in the capacitance is detected by the sensing circuit 330, the processor 120 may transmit a signal for stopping the slide operation of the electronic device 101 and/or a signal for slide-out of the electronic device 101 to the driving structure (e.g., the driving structure 240 in FIG. 4). The user's body may be prevented from being pinched due to the movement (e.g., the sliding movement) of the electronic device 101. By reducing the risk of user's pinching, user convenience may be increased.

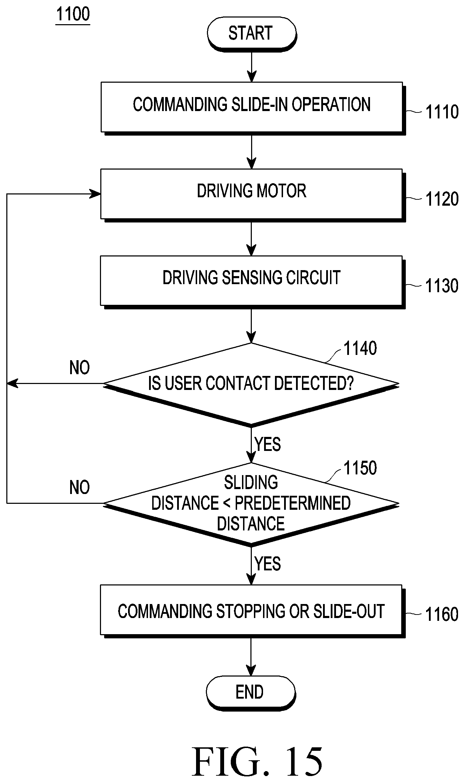

FIG. 15 is a flowchart illustrating the operation of an electronic device according to an embodiment of the disclosure.

In the following embodiments, individual operations may be performed sequentially, but are not necessarily performed sequentially. For example, the order of individual operations may be changed, and at least two operations may be performed in parallel.

According to an embodiment, operations 1110 to 1160 may be understood to be performed by a processor (e.g., the processor 120 in FIG. 1) of an electronic device (e.g., the electronic device 101 in FIGS. 1 to 14).

According to an embodiment, the electronic device (e.g., electronic device 101 in FIGS. 1 to 14) may include at least one memory (e.g., the memory 130 in FIG. 1) that stores at least one instruction. The at least one instruction, when executed by at least one processor (e.g., the processor 120 in FIG. 1), may cause the electronic device 101 to perform at least one operation (e.g., at least one of the operations performed by the electronic device 101 described in this disclosure).

Referring to FIG. 15, an operation of driving an electronic device (e.g., the electronic device 101 in FIG. 2) (operation 1100) may include an operation of commanding slide-in driving (operation 1110), an operation of driving a motor (e.g., the motor 241 in FIG. 6) (operation 1120), an operation of driving a sensing circuit (e.g., the sensing circuit 330 in FIG. 7) (operation 1130), an operation of detecting user contact (operation 1140), an operation of determining a sliding distance (operation 1150), and/or an operation of stopping the electronic device 101 or performing slide-out of the electronic device 101 (operation 1160).

According to an embodiment, the processor (e.g., the processor 120 in FIG. 1) may perform the operation of commanding slide-in driving (operation 1110) and an operation of driving the motor 241. For example, the processor 120 may transmit a signal for slide-in driving of the electronic device 101 to the motor 241 based on a predetermined operation (e.g., user input applied to a key input device (e.g., the key input device 245 in FIG. 2).

According to an embodiment, the processor 120 may perform the operation of driving the sensing circuit 330 (operation 1130). The operation of driving the sensing circuit 330 (operation 1130) may be performed after the operation driving the motor 241 (operation 1120). For example, in an embodiment, power may be supplied to the sensing circuit 330 after power is supplied to the motor 241. In an embodiment, power may be supplied to the motor 241 and the sensing circuit 330 substantially simultaneously. Since the sensing circuit 330 operates based on the driving of the motor 241, the power used by the sensing circuit 330 is reduced, and the power required by the electronic device 101 may be reduced.

According to an embodiment, the processor 120 and/or the sensing circuit 330 can perform an operation of detecting user contact (operation 1140). For example, in an embodiment, the sensing circuit 330 may detect user contact with a metal area (e.g., the metal area 311 in FIG. 8) of a second cover member (e.g., the second cover member 221 in FIG. 3). In an embodiment, the sensing circuit 330 may detect user contact with the rear surface of the second housing 202 using a touch sensor (e.g., the touch sensor 350 in FIG. 7).

According to an embodiment, the processor 120 may control the driving of the electronic device 101 based on the user contact. When the sensing circuit 330 does not detect user contact, the processor 120 may perform the operation of driving the motor (operation 1120). For example, when the sensing circuit 330 does not detect user contact (operation 1140: No), the processor 120 may perform the slide-in operation of the electronic device 101.

According to an embodiment, when the sensing circuit 330 detects user contact (operation 1140: Yes), the processor 120 may perform the operation of determining the sliding distance in the electronic device 101 (operation 1150). For example, the processor 120 may compare the sliding distance in the electronic device 101 with the a predetermined distance. Wen the processor 120 determines that the sliding distance in the electronic device 101 is less than the predetermined distance (operation 1150: Yes), the processor may generate a signal for a command to stop the electronic device 101 or to perform the slide-out operation of the electronic device 101. For example, the processor 120 may transmit a signal to the motor 241 to stop the electronic device 101 or to perform the slide-out of the electronic device 101 when the sensing circuit 330 detects user contact and the sliding distance is determined to be less than the predetermined distance (operation 1150: Yes). By stopping the electronic device 101 or performing slide-out of the electronic device 101, the risk of the user's body being pinched by the electronic device 101 may be reduced. The predetermined distance refers to the distance at which the user's body is likely to get pinched by the electronic device 101, and may be selectively designed based on the design of the electronic device 101.

According to an embodiment, the processor 120 may perform the slide-in operation of the electronic device 101 when it determines that the sliding distance is greater than or equal to the predetermined distance (operation 1150: No). For example, the processor 120 may execute the sliding operation of the electronic device 101 until the first housing 201 and the second housing 202 of the electronic device 101 approach each other up to the predetermined distance. By allowing the user to move fingers during the slide-in operation of the electronic device 101, the slide-in operation of the electronic device 101 may proceed smoothly, enhancing user convenience.

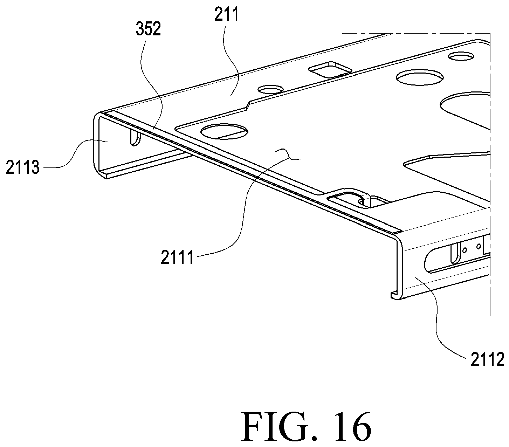

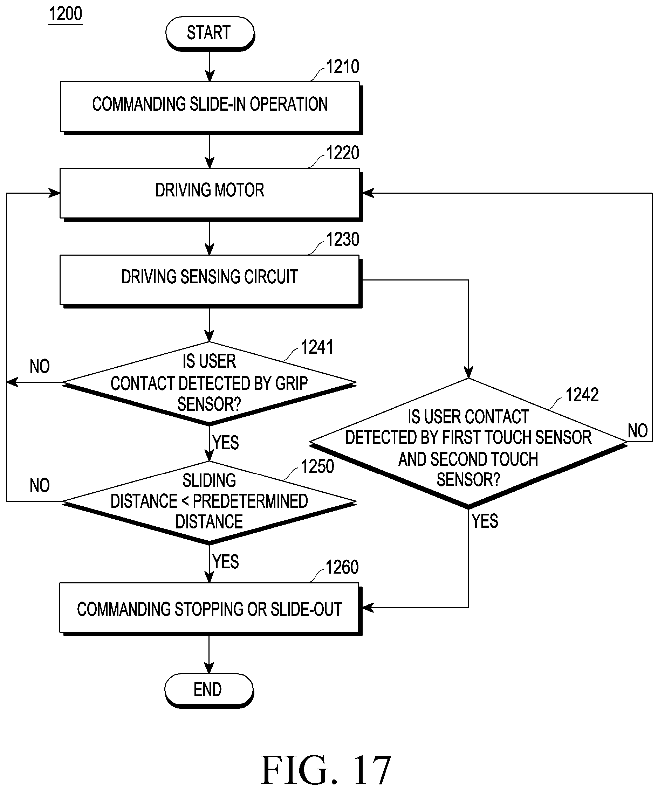

FIG. 16 is a perspective view illustrating an auxiliary touch sensor and a first cover member according to an embodiment of the disclosure. FIG. 17 is a flowchart illustrating the operation of an electronic device according to an embodiment of the disclosure.

Referring to FIG. 16, along with FIG. 7, the electronic device 101 may include a second touch sensor 352. The configurations of the first cover member 211 and the second touch sensor 352 in FIG. 16 may be wholly or partially the same as the configurations of the first cover member 211 and the second touch sensor 352 in FIG. 7.

According to an embodiment, the first cover member 211 may include a rear surface 2111 facing the first rear surface plate of the electronic device 101 (e.g., the first rear surface plate 215 in FIG. 4) and side surfaces 2112 and 2113 extending from the rear surface 2111 and facing the guide rail e.g., the guide rail 250 in FIG. 4).

According to an embodiment, the structure where the second touch sensor 352 is positioned may differ from the structure where the first touch sensor (e.g., the first touch sensor 351 in FIG. 7) is positioned. For example, the second touch sensor 352 may be disposed on a portion of the first housing 201 (e.g., the first cover member 211), while the first touch sensor 351 may be connected to a portion of the second housing 202 (e.g., the second cover member 221). The distance between the first touch sensor 351 and the second touch sensor 352 may vary based on the sliding movement in the electronic device 101. In an embodiment, the second touch sensor 352 may be positioned on the rear surface 2111 of the first cover member 211. Since the second touch sensor 352 is positioned on the rear surface 2111 of the first cover member 211, the second touch sensor 352 may detect user input (e.g., touch) on the rear side of the electronic device 101.

In the following embodiments, individual operations may be performed sequentially, but are not necessarily performed sequentially. For example, the order of respective operations may be changed, and at least two operations may be performed in parallel.

According to an embodiment, operations 1210 to 1260 may be understood to be performed by a processor (e.g., the processor 120 in FIG. 1) of an electronic device (e.g., the electronic device 101 in FIGS. 1 to 14).

According to an embodiment, the electronic device (e.g., electronic device 101 in FIGS. 1 to 14) may include at least one memory (e.g., the memory 130 in FIG. 1) that stores at least one instruction. The at least one instruction, when executed by at least one processor (e.g., the processor 120 in FIG. 1), may cause the electronic device 101 to perform at least one operation (e.g., at least one of the operations performed by the electronic device 101 described in this disclosure).

Referring to FIG. 17, an operation of driving an electronic device (e.g., the electronic device 101 in FIG. 2) (operation 1200) may include an operation of commanding slide-in driving (operation 1210), an operation of driving a motor (e.g., the motor 241 in FIG. 6) (operation 1220), an operation of driving a sensing circuit (e.g., the sensing circuit 330 in FIG. 7) (operation 1230), an operation of detecting user contact by a grip sensor (operation 1241), an operation of detecting user contact by a touch sensor (e.g., the touch sensor 350) (operation 1242), an operation of determining a sliding distance (operation 1250), and/or an operation of stopping the electronic device 101 or performing slide-out of the electronic device 101 (operation 1260).

The operation of driving the electronic device (e.g., the electronic device 101 in FIG. 2) (operation 1200) illustrated in FIG. 17, including the operation that commands slide-in driving (operation 1210), the operation of driving the motor (e.g., the motor (241) in FIG. 6) (operation 1220), and the operation of driving the sensing circuit (e.g., the sensing circuit 330 in FIG. 7) (operation 1230, may be wholly or partially the same as the operation of commanding slide-in driving (operation 1110), the operation driving the motor (e.g., the motor 241 in FIG. 6) (operation 1120, and the operation of driving the sensing circuit (e.g., the sensing circuit 330 in FIG. 7) (operation 1130) illustrated in FIG. 15. The operation of detecting user contact (operation 1140) in FIG. 15 may include the operation that detects user contact by a grip sensor (operation 1241) and/or the operation of detecting user contact by a touch sensor (e.g., the touch sensor 350 in FIG. 7) (operation 1242) illustrated in FIG. 17.

According to an embodiment, the processor 120 may control the driving of the electronic device 101 based on the user contact. In an embodiment, the processor 120 may perform the operation of driving the motor (operation 1220) when electrical signals from the grip sensor (e.g., the connection member 340 in FIG. 7) and the touch sensor 350 are not detected by the sensing circuit 330. For example, when user contact is not detected by the grip sensor and the touch sensor (e.g., the first touch sensor 351 and the second touch sensor 352), the processor 120 may perform the slide-in operation of the electronic device 101.

In an embodiment, when the sensing circuit 330 detects user contact via the grip sensor, the processor 120 may perform the operation of determining the sliding distance in the electronic device 101 (operation 1250). The operation of determining the sliding distance (operation 1250) in FIG. 17 may be substantially the same as the operation of determining the sliding distance in FIG. 15. The grip sensor of the sensing circuit 330 may detect user contact with and/or grip on the electronic device 101 through a metallic area (e.g., the metallic area 311 in FIG. 8) of the second cover member (e.g., the second cover member 221 in FIG. 3) and a connection member (e.g., the connection member 340 in FIG. 7). According to an embodiment, when the sensing circuit 330 detects user contact and the sliding distance is determined to be less than a predetermined distance (operation 1250: Yes), the processor 120 may transmit a signal to the motor 241 to stop the electronic device 101 or to perform the slide-out operation of the electronic device 101. By stopping the electronic device 101 or performing slide-out of the electronic device 101, the risk of the user's body being pinched by the electronic device 101 may be reduced. The predetermined distance refers to the distance at which the user's body is likely to be pinched by the electronic device 101, and may be selectively designed based on the design of the electronic device 101.

According to an embodiment, when the sensing circuit 330 detects user contact via the first touch sensor 351 and the second touch sensor 352 (operation 1242: Yes), the sensing may generate a signal for a command to stop the electronic device 101 or perform the slide-out operation of the electronic device 101. For example, when the user's fingers are positioned within a predetermined range on the first touch sensor 351 and the second touch sensor 352, the processor 120 may generate a signal for a command to stop the electronic device 101 or perform a slide-out operation. When multiple touch sensors 351 and 352 are used, the comparison between the sliding distance and the predetermined distance may be omitted.

An electronic device (e.g., a portable terminal) may include a display having a flat surface or a flat surface and a curved surface. An electronic device including a display may have a limitation in implementing a screen larger than the size of the electronic device due to a fixed display structure. Accordingly, electronic devices including a rollable display are being researched.

The electronic device may include a plurality of housings capable of moving relative to each other. However, as the housings move relative to each other, a user's body (e.g., a finger) may become pinched between the housings.

An embodiment of the disclosure may provide an electronic device and a method of operating the electronic device in which, when a slide-in movement is performed in the electronic device, the user's body may be prevented from being pinched by utilizing a grip sensor and/or a touch sensor.

The problems that the disclosure seeks to solve are not limited to the aforementioned problems, and may be expanded in various ways without departing from the spirit and scope of the disclosure.

According to an embodiment of the disclosure, an electronic device (e.g., the electronic device 101 in FIG. 2) may include a first housing (e.g., the first housing 201 in FIG. 2) including a first cover member (e.g., the first cover 211 in FIG. 4), and a frame (e.g., the frame 213 in FIG. 4) positioned within the first cover member, a second housing (e.g., the second cover member 221 in FIG. 4) (e.g., the second cover 221 in FIG. 4 and/or the second cover member 310 in FIG. 8) at least partially accommodated within the first cover member including a metal area (e.g., the metal area 311 in FIG. 8) and a non-metal area (e.g., the non-metal area 312 in FIG. 8) surrounding the metal area, and configured to slide relative to the first housing, a display (e.g., the display 231 in FIG. 4) configured to be unfolded based on the sliding of the second housing, a circuit board (e.g., the first circuit board 248 in FIG. 4 and/or the circuit board 320 in FIG. 8) disposed within the second housing, a connection member (e.g., the connection member 340 in FIG. 8) contacting the metal area of the second cover member and electrically connecting the metal area to the circuit board, a sensing circuit (e.g., the sensing circuit 330 in FIG. 8) disposed on the circuit board and including a grip sensor configured to detect user contact with the metal area, and at least one application processor (e.g., the processor 120 in FIG. 1) disposed on the circuit board and configured to generate a signal for controlling the movement of the second housing based on an electrical signal detected by the sensing circuit.

According to an embodiment, the electronic device 101 may include memory (e.g., the memory 130 in FIG. 1) configured to store instructions. The instructions, when executed by the at least one application processor 120, may cause the electronic device to perform at least one operation. The at least one operation may include generating a signal to control movement of the second housing based on an electrical signal detected by the sensing circuit.

According to an embodiment, the second cover member may include a first side surface area (e.g., the first side surface area 314 in FIG. 8), and a second side surface area (e.g., the second side surface area 315 in FIG. 8) facing away from the first side surface area. The connection member may include a first connection member (e.g., the first connection member 341 in FIG. 9) contacting a first metal area (e.g., the first metal area 311a in FIG. 8) and forming at least a portion of the first side surface area, and a second connection member (e.g., the second connection member 342 in FIG. 11) contacting a second metal area (e.g., the second metal area 311b in FIG. 8) and forming at least a portion of the second side surface area.

According to an embodiment, the circuit board may include a first board (e.g., the first board 321 in FIG. 8) accommodating the sensing circuit and the application processor, a second board (e.g., the second board 322 in FIG. 8) accommodating the first connection member, and a third board (e.g., the third board 323 in FIG. 8) accommodating the second connection member.

According to an embodiment, The application processor may stop the second housing or change the electronic device to a slide-out state when the user contact is detected by the grip sensor.

According to an embodiment, the memory 130 may include instructions. The instructions, when executed by the at least one application processor 120, may cause the electronic device to perform at least one operation. The at least one operation may further include stopping the second housing or changing the electronic device to the slide-out state when the user contact is detected by the grip sensor.

According to an embodiment, the application processor may stop the second housing or change the electronic device to the slide-out state when the distance of the second housing to the first housing is less than a predetermined distance.

According to an embodiment, the memory 130 may include instructions. The instructions, when executed by the at least one application processor 120, may cause the electronic device to perform at least one operation. The at least one operation may further include stopping the second housing or changing the electronic device to the slide-out state when the distance of the second housing to the first housing is less than a predetermined distance.

According to an embodiment, the second housing may include a rear cover (e.g., the rear cover 223 in FIG. 8) covering at least a portion of the circuit board, and a rear surface plate (e.g., the rear surface plate 225 in FIG. 8) covering at least a portion of the rear cover.

According to an embodiment, the electronic device may further include a first touch sensor (e.g., the first touch sensor 351 in FIG. 8) positioned between the rear cover and the rear surface plate. The application processor may generate a signal to control the movement of the second housing based on an electrical signal detected by the first touch sensor.

According to an embodiment, the memory 130 may include instructions. The instructions, when executed by the at least one application processor 120, may cause the electronic device to perform at least one operation. The at least one operation may include generating a signal to control the movement of the second housing based on an electrical signal detected by the first touch sensor.

According to an embodiment, the electronic device may include a second touch sensor (e.g., the second touch sensor 352 in FIG. 8) disposed on the rear surface (e.g., the rear surface 2111 in FIG. 16) of the first cover member.

According to an embodiment, the application processor may detect user contact at the first touch sensor and the second touch sensor, and generate an electrical signal for stopping the movement of the second housing or for slide-out of the electronic device.

According to an embodiment, the memory 130 may include instructions. The instructions, when executed by the at least one application processor 120, may cause the electronic device to perform at least one operation. The at least one operation may further include detecting user contact at the first touch sensor and the second touch sensor, and generating an electrical signal for stopping the movement of the second housing or for slide-out of the electronic device.

According to an embodiment, the grip sensor may detect a change in dielectric constant of the electrical signal transmitted via the connection member.

According to an embodiment, the second cover member may include a side wall (e.g., the side wall 316 in FIG. 8) covered by the first cover member in the slide-in state of the electronic device, and a protrusion (e.g., the protrusion 317 of FIG. 8) protruding from the side wall and exposed to the outside of the electronic device in the slide-in state of the electronic device.

According to an embodiment, the metal area may be positioned in a portion of the side wall and a portion of the protrusion.

According to an embodiment, the electronic device may include a multi-bar structure (e.g., the multi-bar structure 232 in FIG. 4) configured to support at least a portion of the display, a guide rail (e.g., the guide rail 250 in FIG. 4) comprising a slit (e.g., the slit 251 in FIG. 4) configured to guide the movement of the multi-bar structure, and connected to the frame.

According to an embodiment, the electronic device may include a driving structure (e.g., the driving structure 240 of FIG. 6) configured to slide the second housing relative to the first housing. The driving structure may be configured to generate a driving force for moving the second housing relative to the first housing, and may include a motor (e.g., the motor 241 in FIG. 6) disposed within the frame, a gear (e.g., the gear 244 in FIG. 6) connected to the motor, and a rack (e.g., the rack 242 in FIG. 6) connected to the second housing and configured to be engaged with the gear.

According to an embodiment, the application processor may be configured to operate the sensing circuit after the motor operates.

According to an embodiment of the disclosure, an electronic device (e.g., the electronic device 101 in FIG. 2) may include a first housing (e.g., the first housing 201 in FIG. 4) including a first cover member (e.g., the first cover 211 in FIG. 4), and a frame (e.g., the frame 213 in FIG. 4) positioned within the first cover member, a second housing (e.g., the second housing (202) of FIG. 4) configured to slide relative to the first housing, and including a second cover member (e.g., the second cover member 221 in FIG. 4) at least partially accommodated within the first cover member, a rear cover (e.g., the rear cover 223 in FIG. 4) covering at least a portion of the second cover member, and a rear surface plate (e.g., the second rear surface plate 223 in FIG. 4) covering at least a portion of the rear cover, a display (e.g., the display 203 in FIG. 3) configured to be unfolded based on the sliding of the second housing, a circuit board (e.g., the first circuit board 248 in FIG. 4 and/or the circuit board 320 in FIG. 7) disposed within the second housing, a touch sensor (e.g., the touch sensor 350 in FIG. 8) positioned between the second cover member and the second rear surface plate and configured to detect user input, a sensing circuit (e.g., the sensing circuit 330 in FIG. 8) disposed on the circuit board and configured to detect the user contact with the touch sensor, and at least one application processor (e.g., the processor 120 in FIG. 1) disposed on the circuit board and configured to generate a signal for controlling the movement of the second housing based on an electrical signal determined in the sensing circuit.

According to an embodiment, the electronic device 101 may include memory (e.g., the memory 130 in FIG. 1) configured to store instructions. The instructions, when executed by the at least one application processor 120, may cause the electronic device to perform at least one operation. The at least one operation may include generating a signal to control movement of the second housing based on an electrical signal determined by the sensing circuit.

According to an embodiment, the application processor may stop the second housing or change the electronic device to a slide-out state when the user contact is detected by the touch sensor.

According to an embodiment, the memory 130 may include instructions. The instructions, when executed by the at least one application processor 120, may cause the electronic device to perform at least one operation. The at least one operation may further include stopping the second housing or changing the electronic device to the slide-out state when the user contact is detected by the touch sensor.

According to an embodiment, the electronic device may include an auxiliary touch sensor (e.g., the second touch sensor 352 in FIG. 16) disposed on the rear surface (e.g., the rear surface 2111 in FIG. 16) of the first cover member. When the user contact is detected at the touch sensor and the auxiliary touch sensor, the application processor may generate an electrical signal for stopping the movement of the second housing or for slide-out of the electronic device.

According to an embodiment, the memory 130 may include instructions. The instructions, when executed by the at least one application processor 120, may cause the electronic device to perform at least one operation. The at least one operation may include, when the user contact is detected at the touch sensor and the auxiliary touch sensor, generating an electrical signal for stopping the movement of the second housing or for slide-out of the electronic device.

According to an embodiment, the electronic device may include a driving structure (e.g., the driving structure 240 of FIG. 6) configured to slide the second housing relative to the first housing. The driving structure may be configured to generate a driving force for moving the second housing relative to the first housing, and may include a motor (e.g., the motor 241 in FIG. 6) disposed within the frame, a gear (e.g., the gear 244 in FIG. 6) connected to the motor, and a rack (e.g., the rack 242 in FIG. 6) connected to the second housing and configured to be engaged with the gear. The sensing circuit may be configured to operate after the motor is activated.

According to an embodiment of the disclosure, an electronic device (e.g., the electronic device 101 in FIG. 2) may include a first housing (e.g., the first housing 201 in FIG. 4) including a first cover member (e.g., the first cover 211 in FIG. 4), and a frame (e.g., the frame 213 in FIG. 4) positioned within the first cover member, a second housing (e.g., the second housing 202 in FIG. 4) configured to slide relative to the first housing and including a second cover member (e.g., the second cover member 310 in FIG. 8) at least partially accommodated within the first cover member, the second cover member including a metal area (e.g., the metal area 311 in FIG. 8) and a non-metal area (e.g., the non-metal area 312 in FIG. 8) surrounding the metal area, a display (e.g., the display 203 in FIG. 4) configured to be unfolded based on the sliding of the second housing, a circuit board (e.g., the first circuit board 248 in FIG. 4 and/or the circuit board 310 in FIG. 7) disposed within the second housing, a connection member (e.g., the connection member 340 in FIG. 7) that is in contact with the metal area of the second cover member and electrically connects the metal area to the circuit board, a touch sensor (e.g., the touch sensor 350 in FIG. 7) disposed on the second cover member and configured to detect user input, a sensing circuit (e.g., the sensing circuit 330 in FIG. 7) disposed on the circuit board and configured to determine user contact relative to at least one of the connection member or the touch sensor, and at least one application processor (e.g., the processor 120 in FIG. 1) disposed on the circuit board and configured to generate a signal for controlling the movement of the second housing based on an electrical signal detected by the sensing circuit.

According to an embodiment, the electronic device 101 may include memory (e.g., the memory 130 in FIG. 1) configured to store instructions. The instructions, when executed by the at least one application processor 120, may cause the electronic device to perform at least one operation. The at least one operation may include generating a signal to control movement of the second housing based on an electrical signal detected by the sensing circuit.

It may be apparent to a person ordinarily skilled in the technical field to which the disclosure belongs that an electronic device including the above-described sensing circuit of the disclosure is not limited by the above-described embodiments and drawings, and can be variously substituted, modified, and changed within the technical scope of the disclosure.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. **In** such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device (101) comprising:
a first housing (201) comprising a first cover member (211) and a frame (213) positioned within the first cover member;
a second housing (202) comprising a second cover member (221, 310) at least partially accommodated within the first cover member and including a metal area (311), and a non-metal area (312) surrounding the metal area, and configured to slide relative to the first housing;
a display (203, 231) configured to be unfolded based on the sliding of the second housing;
a circuit board (248, 320) disposed within the second housing;
a connection member (340) contacting the metal area of the second cover member and electrically connecting the metal area to the circuit board;
a sensing circuit (330) disposed on the circuit board and comprising a grip sensor configured to detect user contact with the metal area;
at least one application processor (120) disposed on the circuit board; and
memory (130) storing instructions that, when executed by the at least one application processor (120), cause the electronic device to perform at least one operation,
wherein the at least one operation comprises generating a signal to control movement of the second housing based on an electrical signal detected by the sensing circuit.

2. The electronic device of claim 1, wherein the second cover member comprises a first side surface area (314), and a second side surface area (315) facing away from the first side surface area, and
wherein the connection member comprises a first connection member (341) contacting a first metal area (311a) and forming at least a portion of the first side surface area, and a second connection member (342) contacting a second metal area (311b) and forming at least a portion of the second side surface area.

3. The electronic device of claim 1 or 2, wherein the circuit board comprises a first board (321) accommodating the sensing circuit and the application processor, a second board (322) accommodating the first connection member, and a third board (323) accommodating the second connection member.

4. The electronic device of any one of the preceding claims, wherein the at least one operation further comprises:
stopping the second housing or changing the electronic device to a slide-out state when the user contact is detected by the grip sensor.

5. The electronic device of any one of the preceding claims, wherein the at least one operation further comprises:
stopping the second housing or changing the electronic device to a slide-out state when a distance of the second housing to the first housing is less than a predetermined distance.

6. The electronic device of any one of the preceding claims, wherein the second housing comprises a rear cover (223) covering at least a portion of the circuit board, and a rear surface plate (225) covering at least a portion of the rear cover.

7. The electronic device of to any one of the preceding claims, further comprising:
a first touch sensor (351) positioned between the rear cover and the rear surface plate,
wherein the at least one operation further comprises:
generating a signal to control movement of the second housing based on an electrical signal detected by the first touch sensor.

8. The electronic device of any one of the preceding claims, further comprising:
a second touch sensor (352) disposed on a rear surface (2111) of the first cover member.

9. The electronic device of any one of the preceding claims, wherein the at least one operation further comprises:
stopping movement of the second housing or generating an electrical signal for slide-out of the electronic device when the user contact is detected by the first touch sensor and the second touch sensor.

10. The electronic device of any one of the preceding claims, wherein the grip sensor is configured to detect a change in dielectric constant of the electrical signal transmitted via the connection member.

11. The electronic device of any one of the preceding claims, wherein the second cover member comprises:
a side wall (316) covered by the first cover member in a slide-in state of the electronic device; and
a protrusion (317) extending from the side wall and exposed to an outside of the electronic device in the slide-in state.

12. The electronic device of any one of the preceding claims, wherein the metal area is positioned on a portion of the side wall and a portion of the protrusion.

13. The electronic device of any one of the preceding claims, further comprising:
a multi-bar structure (232) configured to support at least a portion of the display; and
a guide rail (250) comprising a slit (251) configured to guide movement of the multi-bar structure, and connected to the frame.

14. The electronic device of any one of the preceding claims, further comprising:
a driving structure (240) configured to slide the second housing relative to the first housing,
wherein the driving structure comprises:
a motor (241) disposed within the frame and configured to generate a driving force for moving the second housing relative to the first housing;
a gear (244) connected to the motor; and
a rack (242) connected to the second housing and configured to be engaged with the gear.

15. The electronic device of any one of the preceding claims, wherein the sensing circuit is configured to operate after the motor is activated.
